# FASCICULE DE BREVET EUROPEEN

(11) **EP 1 932 804 B1**
(45) Date de publication et mention de la délivrance du brevet: **22.03.2017**
(21) Numéro de dépôt: 07122526.2
(22) Date de dépôt: 06.12.2007
(51) Int. Cl.: B81C 99/00, G04B 13/02, G04D 3/00

(54) **Pièces mixtes silicium/métal et méthodes de fabrication s'y référant**
Silizium-Metall-Mischteile und damit verbundene Herstellungsverfahren
Mixed silicon/metal parts and associated manufacturing methods

(30) Priorité: 11.12.2006 CH 20062006
(43) Date de publication de la demande: 18.06.2008
(73) Titulaire: Mimotec S.A., 1950 Sion (CH)
(72) Inventeur: Lorenz, Hubert, 1965, Granois (Savièse) (CH); Genolet, Grégoire, 1926, Fully (CH); Glassey, Marc-André, 1967, Bramois (CH)
(74) Mandataire: Leman Consulting S.A.

(56) Documents cités:
- EP-A1- 0 164 333
- EP-A1- 1 640 333
- EP-A1- 1 688 994
- EP-A1- 1 722 281

## Description

### Introduction

La présente demande concerne le domaine de la fabrication de microstructures mixtes silicium-métal sur base silicium réalisée par gravure profonde.

### Etat de la technique

Le procédé de fabrication de micro-composants par gravure de silicium est bien connu. Des pièces compliquées, de grande précision et d'une grande résistance sont réalisées par méthode de gravure profonde de silicium. Une fois cette gravure faite, la pièce est détachée de son support (généralement du verre, du silicium ou de l'aluminium) par attaque chimique.

La pièce ainsi formée peut être très compliquée et de grande précision. Une telle précision ne peut être atteinte par usinage traditionnel mais nécessite des procédés de micro-fabrication.

Une fois cette pièce disponible, elle est utilisée dans le dispositif final (mouvement de montre, capteur miniature, micro-moteur par exemple) et vient interagir avec les autres pièces du dispositif, par exemple chassée sur un axe. Il arrive fréquemment que lors de cette étape de montage, la pièce en silicium casse du fait de sa grande fragilité.

Il existe plusieurs méthodes pour graver du silicium en utilisant une réaction chimique pour attaquer sélectivement ce dernier. Des techniques de micro-fabrication connues sous l'appellation "Wet Etching", "Dry Etching", "Reactive Ion Etching", "Deep Reactive Ion Etching" and "Focus Ion Beam milling, FIB" sont utilisées à cet effet. Le point commun entre ces différentes technologies est l'utilisation d'un masque afin de sélectionner les parties qui seront attaquées lors de l'opération de gravure, sauf pour le cas du FIB. La solution la plus précise a été développée par Bosch et permet de structurer des épaisseurs allant jusqu'à 1 mm. La particularité de cette méthode est la possibilité de disposer de gravure profonde tout en préservant des flancs de paroi verticaux.

Le document EP1722281A1 décrit un organe d'affichage analogique équipant une pièce d'horlogerie comportant un corps principal réalisé en matériau cristallin à base de silicium et un procédé de fabrication de tels organes d'affichage. Le procédé comporte au moins une étape de micro usinage d'une plaque en matériau cristallin à base de silicium de manière à réaliser au moins un corps principal en un tel matériau cristallin. Selon un exemple particulier, l'organe d'affichage analogique est une aiguille de montre prévue pour être liée en rotation à un axe ou une roue du mouvement horloger de la montre. A cet effet l'aiguille, pourvue d'un trou d'axe, est destinée à être chassée sur un axe d'entraînement. Selon une variante, la surface axiale interne du trou d'axe est pourvue d'une couche de matériau destinée à permettre le chassage de l'aiguille par déformation de la couche ou par glissement contre la couche, en limitant les risques de rupture du corps principal. Selon une autre variante de réalisation, l'aiguille peut être collée ou soudée sur l'axe d'entraînement.

Le document EP1688994A1 décrit un capot de protection au niveau d'une galette semi-conductrice et sa méthode de fabrication. Le capot recouvrant une galette de composants sur laquelle se situe un composant comprend une galette formant un capot comportant sur une surface de fond une cavité constituant un espace pour recevoir le composant et une pluralité lignes métalliques disposées sur le fond et intégrée à la galette de composants. Ces lignes correspondent à une pluralité de points de connexion formés sur la galette de composants destinés à être connectés électriquement au composant. La galette de composants comprend de plus une pluralité de parties tampon connectées à la pluralité de lignes métalliques et comprenant une galette tampon avec une pluralité de rainures remplies d'un métal, une pluralité de tiges de connexion connectées électriquement à la pluralité de parties tampon et pénétrant dans la galette capot à partir d'une partie supérieure de la partie tampon et une pluralité de points de connexion du capot formés sur une surface supérieure de la galette capot et connectée électriquement à une pluralité de tiges de connexion. La méthode de fabrication comprend des étapes de formation par photolithographie de cavités et de trous de connexion dans la galette de composants et de dépôt galvanique de métal notamment pour remplir les rainures de la galette tampon et pour former les tiges de connexion reliant les lignes métallique aux points de connexion de la surface supérieure de la galette capot.

Le document EP1640333A1 décrit un micro-dispositif comprenant une microstructure et un canal d'évent dans une galette disposée en sandwich entre en substrat et un capot. Le capot et le substrat comportent autour de la microstructure des renfoncements définissant une cavité. Un évent, connecté au canal d'évent qui est relié à la cavité, est utilisé pour faire le vide dans la cavité et sceller la microstructure. Une couche d'absorption peut être utilisée pour maintenir le vide dans la cavité. Une connexion électrique est effectuée à travers l'évent, le canal d'évent et la cavité afin de mettre la couche d'absorption à la masse électrique. Le document EP1640333A1 décrit également une méthode simple d'encapsulation hermétique d'un micro-dispositif sous vide muni d'un canal d'évent.

Quelle que soit la technique utilisée, la pièce finale résultante est fragile et donc peut se briser très facilement dès lors que ladite pièce doit être assemblée avec d'autres éléments.

### Brève description de l'invention

Le but de la présente invention est de produire des pièces en silicium par gravure du silicium comportant une ou des parties métalliques.

Ce but est atteint par une méthode de fabrication de pièces mixtes silicium/métal, la partie métallique étant obtenue par croissance de ladite partie métallique. Cette méthode comprend au moins les étapes suivantes : Photolithographie, Gravure du silicium, Dépôt d'un photorésist épais, Photolithographie ; Electroformage dans ou autour d'une surface gravée. Un procédé complet pour atteindre le but est décrit ci dessous à savoir :
a) dépôt sur un substrat de base d'au moins une couche conductrice,
b) dépose et liaison d'une plaque de silicium sur le substrat,
c) application d'une première couche de photorésist sur le silicium,
d) polymérisation au travers d'un premier masque de la première couche de photorésist et élimination de la couche de photorésist non polymérisée,
e) gravure profonde de la plaque de silicium selon le tracé de la couche non polymérisée,
f) élimination de la première couche de photorésist,
g) dépôt d'une seconde couche de photorésist,
h) polymérisation au travers d'un second masque de la seconde couche de photorésist et élimination de la couche de photorésist non polymérisée,
i) dépôt d'un métal par électroformage sur la couche conductrice du substrat de base de sorte que la croissance de la couche métallique remplit d'une part le volume défini par la gravure dans la plaque de silicium et d'autre part le volume défini par la couche de photorésist épais polymérisé,
j) obtention de la pièce mixte par élimination de la couche de photorésist épais et séparation du substrat de base.

La présente demande concerne également un produit fini sous la forme d'une pièce mixte comprenant une partie métallique et une partie en silicium, caractérisée en ce que la partie en silicium comprend au moins une cavité traversante dans laquelle la partie métallique est déposée par électroformage.

Ainsi, grâce à la combinaison de la technique de gravure du silicium et l'électroformage, il est possible d'obtenir une pièce unique finie sur base de silicium comprenant la ou les parties métalliques liées au silicium par croissance.

Les procédés de photolithographie servant à la structuration des deux matériaux étant très précis, la nouvelle pièce mixte ainsi formée sera bien plus précise que s'il s'agissait d'un assemblage de pièces.

Grâce au procédé décrit ci-dessus, il est possible de réaliser des pièces mixtes silicium/métal liées par croissance du métal sur le silicium. De cette manière on peut exploiter les deux types de matériaux et leurs caractéristiques dans la nouvelle pièce assemblée. Par caractéristiques spécifiques on peut noter dans le cas de l'utilisation du nickel comme métal : la conductivité électrique (Si oui et non, Ni oui), le magnétisme (Si non, Ni oui), le poids spécifique (Si léger ; Ni lourd), la déformabilité plastique pour rivetage ou assemblage (Si non, Ni oui), la soudabilité (Si non , Ni oui), et des coefficients de frottement différents.

La liaison entre la plaque de silicium et la partie métallique est dite intime c'est-à-dire résultant de la croissance par électroformage de la partie métallique le long des flancs de la plaque de silicium.

### Brève description des figures

L'invention sera mieux comprise grâce à la description détaillée qui va suivre en se référant aux dessins annexés dans lesquels :
- les figures 1 et 2 illustrent l'assemblage des différents éléments de base pour la fabrication d'une pièce en silicium,
- la figure 3 illustre la photolithographie du premier masque,
- la figure 4 illustre la plaque de silicium gravée avec le premier masque,
- la figure 5 illustre la plaque de silicium après dissolution du masque,
- la figure 6 illustre l'étape de dissolution de la couche intermédiaire de photorésist,
- la figure 7 illustre le dépôt du photorésist épais,
- la figure 8 illustre le moule en photorésist épais après structuration selon le second masque,
- la figure 9 illustre l'étape d'électroformage dans le moule de silicium et photorésist,
- la figure 10 illustre la pièce mixte finie selon l'invention,
- les figures 11 à 14 illustre une exécution particulière résultant en la fabrication d'une planche en silicium et d'un pignon en métal,
- les figures 15 à 17 illustrent une exécution utilisant des moules en photorésist de plusieurs couches.
- La figure 18 illustre une réalisation dans laquelle la partie métallique déborde nettement de la cavité de la plaque de silicium,
- La figure 19 illustre une exécution à deux niveaux pour la partie métallique,
- La figure 20 illustre un assemblage de deux plaques de silicium
- La figure 21 illustre une pièce avec croissance métalliques multiples.

### Description détaillée

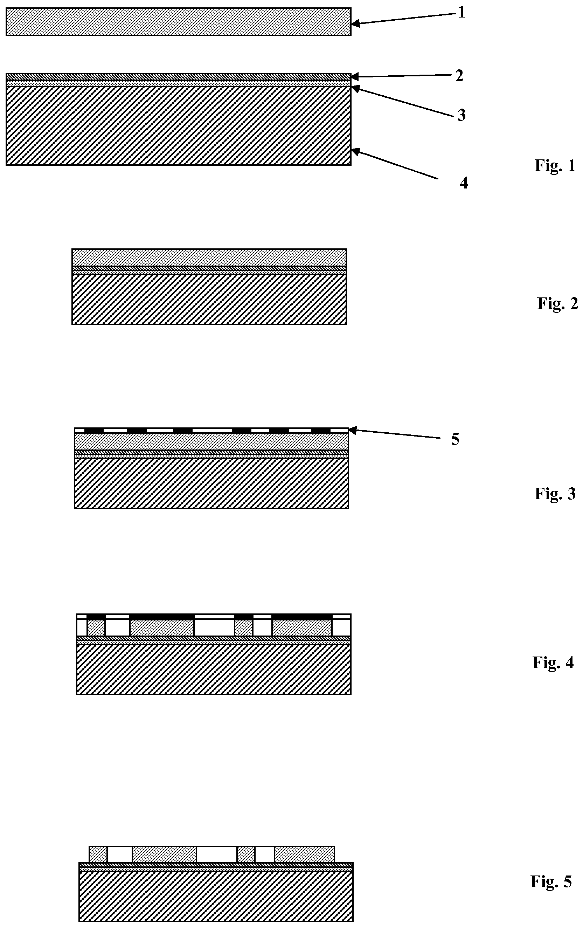

Sur la figure 1 est illustrée la préparation de la première étape qui concerne la gravure du silicium. Sur le substrat de base 4 est appliquée une couche conductrice 3 réalisée généralement par dépôt de chrome/or ou titane/or. Sur cette couche est appliquée une couche intermédiaire de photorésist 2 qui servira pour la liaison de la plaque en silicium à graver. Finalement on place une plaque de silicium 1 destinée à la gravure.

La figure 2 montre l'assemblage de ces 4 éléments. L'assemblage peut être réalisé par d'autres méthodes que par une couche mince de photorésist. La liaison peut être sans apport de matière telle qu'électrostatique, thermique ou par pression. Pour une liaison avec apport de matière, elle utilisera tout type de couche adhésive. L'assemblage peut également être réalisé par électroformage du substrat (4 dans figure 1) dans le cas d'un substrat métallique.

On dépose ensuite une couche de photorésist 5 et un masque au travers duquel on polymérise la couche de photorésist 5 suivant le dessin du masque. On élimine la couche de photorésist polymérisée ou non-polymérisée 5 (selon le type de photorésist utilisé) afin de conserver une protection sur les zones non soumises à l'opération de gravure. Le masque de photorésist 5 définit les zones qui seront attaquées par la gravure du silicium. Le résultat est illustré sur la figure 3.

La figure 4 illustre la plaque de silicium après l'opération de gravure selon des techniques connues telles que la D-RIE (Deep Reactive Ion Etching). Ce procédé, développé par Bosch fait l'objet d'un brevet DE 4241045. On peut dans ce cas imaginer d'autres techniques de gravure.

Le résultat de cette opération de gravure est illustré à la figure 4. La gravure s'arrête sur la couche intermédiaire de photorésist 2.

La couche de photorésist sur la plaque de silicium est dissoute et l'on obtient l'ensemble illustré à la figure 5.

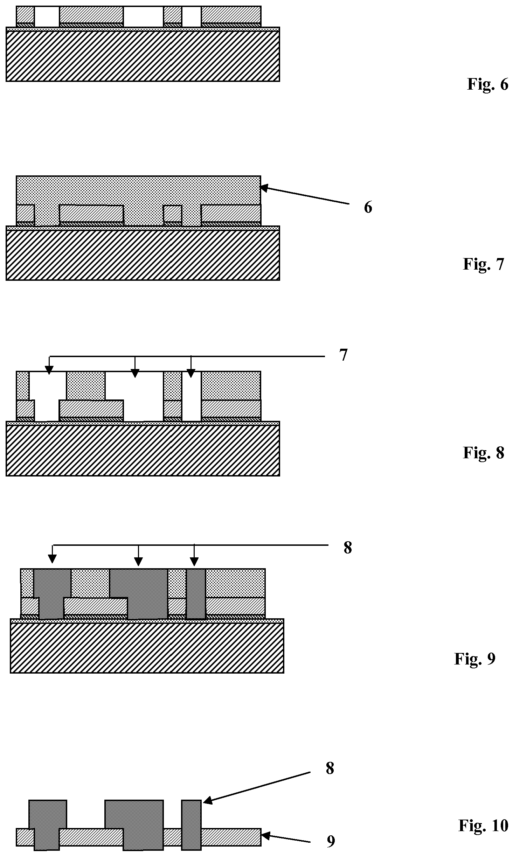

Sur la figure 6 est illustrée l'opération suivante qui consiste à dévoiler la couche conductrice par illumination de la couche intermédiaire de photorésist puis dissolution de ladite couche.

On applique ensuite une couche de photorésist épais 6 dont l'épaisseur sera choisie en fonction de la taille de la partie métallique qui fera partie intégrante de cette pièce mixte. Ceci est illustré à la figure 7.

La figure 8 illustre l'étape suivante qui consiste à enlever le photorésist épais là où le métal sera électro-déposé. Ceci est réalisé par le placement d'un masque sur le photorésist épais, illumination, polymérisation et dissolution du photorésist non polymérisé pour créer un moule en photorésist. On obtient l'ensemble de la figure 8.

L'ensemble est maintenant prêt pour l'opération d'électroformage. Du métal 8 est déposé dans les cavités 7 de la gravure de la plaque de silicium et dans le photorésist épais. Une fois l'électroformage terminé tel qu'illustré à la figure 9, il reste à dissoudre le photorésist et séparer la plaque de silicium du substrat de base.

On obtient une pièce mixte telle que représentée à la figure 10 dont une première partie est en silicium 9 et une seconde partie est en métal 8 obtenu par électroformage. Les parties métalliques pourront servir d'axe ou d'actuateur par exemple.

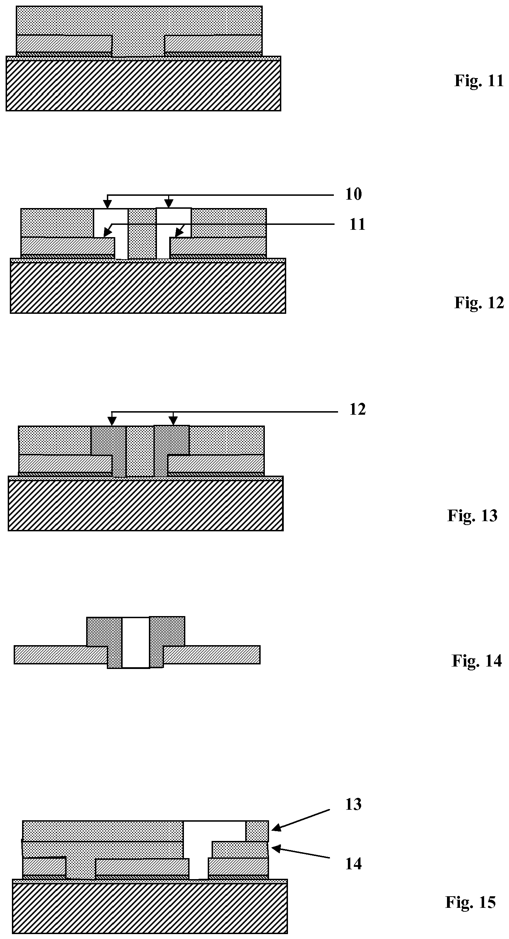

Un autre exemple de réalisation est illustré par les figures 11 à 14 pour une pièce mixte finale qui comprend un trou d'axe dans la partie métallique. Les ouvertures 10 faites dans le photorésist de la figure 12 vont être comblées de parties métalliques et donc laisser une ouverture après dissolution du photorésist qui pourra être le trou d'axe de la pièce mixte.

Afin de faciliter une répartition homogène des parties métalliques lors du passage de la plaque de silicium au moule de photorésist, on peut appliquer une couche conductrice supérieure 11 sur la partie supérieure de la plaque de silicium avant le dépôt de la couche de photorésist épais. Ceci est réalisé par dépôt sélectif d'or afin que seules les parties horizontales soient recouvertes d'une couche conductrice.

Grâce à cette couche conductrice supérieure 11 placée sur la plaque de silicium, les parties métalliques, lors de l'électroformage, vont croitre dans la cavité de la plaque de silicium jusqu'à atteindre le niveau supérieur de ladite plaque et donc mettre en contact électrique la couche conductrice supérieure 11. A ce moment, la croissance métallique se fera d'une manière très homogène quelque soit la taille de la cavité définit par le moule de photorésist. En final, les parties métalliques 12 représentées sur la figure 13 rempliront toute la cavité de la plaque de silicium et de la cavité du moule de photorésist.

La pièce finale est représentée à la figure 14.

Un exemple de réalisation utilisant un moule photorésist multi-niveaux est représenté à la figure 15. Un premier masque sur une première couche 14 de photorésist est illuminé, polymérisé et dissout, puis une deuxième couche de photorésist 13 est applique sur le premier moule et la même opération est répétée avec un second masque. L'élément final est représenté à la figure 15 et montre ainsi la diversité des formes que l'on peut obtenir. Il est bien entendu possible d'ajouter d'autres niveaux en répétant l'opération.

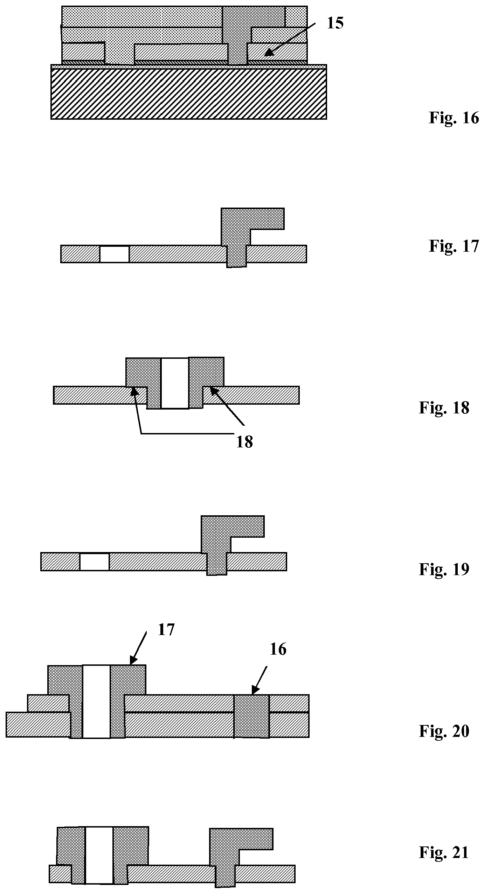

Sur la figure 16 on remarquera que la partie métallique 15 prend la forme définie par les deux moules de photorésist (première couche de photorésist et seconde couche de photorésist épaisse) et la cavité de la gravure de la plaque de silicium. A noter qu'il n'est pas nécessaire que toutes les cavités de la plaque de silicium soient comblées par des parties métalliques.

On voit ainsi sur la figure 17 que la partie en silicium dispose d'un orifice et d'une partie métallique selon la forme choisie.

Sur la figure 18, on observe que la partie métallique dépasse des deux côtés de la plaque de silicium. Ceci est possible par l'utilisation d'une couche intermédiaire de photorésist plus épaisse. On choisira l'épaisseur de cette couche intermédiaire en fonction de l'épaisseur souhaitée de la partie métallique s'étendant au delà du plan de la plaque de silicium.

Lorsque le moule de photorésist définit une surface notablement plus grande que la cavité de la plaque de silicium, comme représenté à la figure 18, il est conseillé de déposer une couche conductrice sur la plaque de silicium aux endroits 18 prévus pour le dépôt de métal. La précision n'est pas requise puisque c'est la seconde couche de photorésist qui va définir précisément la forme de la partie métallique. Lors de la croissance métallique, une fois la cavité de la plaque de silicium remplie, une conduction électrique se fera sur la couche déposée sur la plaque de silicium et la métallisation sera répartie d'une manière homogène sur toute la surface laissée libre par la seconde couche de photorésist.

Un tel dépôt d'une couche conductrice peut être également effectué sur une couche inférieure de photorésist dans le cas d'une partie métallique à plusieurs niveaux tel qu'illustré à la figure 15. Le dépôt de cette couche conductrice se fera sur la seconde couche de photorésist, au moins aux endroits laissés accessibles par la troisième couche de photorésist.

La figure 19 illustre la pièce finie tel que produite par l'ensemble de la figure 16. On peut voir un orifice sur la plaque en silicium réalisé par gravure qui n'est pas utilisé pour la métallisation.

La figure 20 illustre un assemblage comprenant deux plaques de silicium. Il est à noter que la gravure sur la plaque de silicium peut se faire lors d'une étape séparée puis ladite plaque est placée sur le substrat. Pour assurer la liaison entre les plaques, on s'arrangera qu'au moins une cavité sur la première plaque soit au droit d'une cavité de la seconde plaque. La cavité de la seconde plaque sera d'une taille égale ou supérieure à la cavité de la première plaque. La croissance métallique va les lier définitivement. La partie métallique est intimement liée avec chacune d'elle. On pourra ajouter des orifices dans les plaques uniquement pour créer cette liaison (voir point 16 de la figure 20). Dans ce cas, si une même couche de photorésist est utilisée pour l'opération de métallisation, la hauteur de l'élément de liaison 16 sera de la même hauteur que les autres parties métalliques 17. Pour obtenir une hauteur de l'élément de liaison 16 à fleur de la plaque de silicium, deux passages de métallisation sont nécessaires, chaque passage correspondant à une couche de photorésist. Lors du premier passage, les autres parties métalliques 17 seront recouvertes par le premier photorésist et la métallisation va former les éléments de liaison 16. Après dissolution de la première couche de photorésist et application de la seconde, cette dernière recouvrira les éléments de liaison et laissera libres les autres parties métalliques 17.

Une autre manière d'électroformer des éléments de liaisons uniquement est d'utiliser la couche intermédiaire. Avant l'assemblage du substrat et de la plaque de silicium, la couche intermédiaire de photorésist est dissoute uniquement aux endroits destinés aux éléments de liaison. Il reste encore suffisamment de photorésist pour assurer une bonne liaison entre la plaque de silicium et le substrat. La métallisation se fera uniquement aux endroits conducteurs à savoir pour la formation du ou des éléments de liaisons. Après cette opération, la couche de photorésist intermédiaire est dissoute, laissant apparaître la partie conductrice sous les cavités où viendra se former les autres parties métalliques.

La figure 21 illustre la réalisation d'une pièce mixte utilisant deux parties métalliques et deux niveaux de moule photorésist.

Bien que la présente demande soit illustrée par des moules de photorésist à une ou deux couches, il est possible également d'utiliser plus de deux couches si la forme des parties métalliques l'impose. De la même manière il est possible d'utiliser plus de deux plaques de silicium pour réaliser des parties en silicium de différentes formes.

## Revendications

1. Pièce mixte micromécanique de mouvement de montre destinée à interagir avec d'autres pièces du mouvement de montre comprenant une partie métallique (8) et une partie en silicium (9), **caractérisée en ce que** la partie en silicium (9) comprend au moins une cavité (7) traversante dans laquelle la partie métallique (8) est liée de manière intime à la partie en silicium (9) résultant de la croissance de ladite partie métallique (8) dans ladite cavité (7).

2. Pièce mixte micromécanique selon la revendication 1, **caractérisée en ce que** la partie en silicium (9) comprend au moins une cavité (7) vide et au moins une cavité (7) avec partie métallique (8).

3. Pièce mixte micromécanique selon la revendication 1 ou 2, **caractérisée en ce qu'**elle comprend l'assemblage d'au moins deux plaques de silicium superposées, au moins une cavité de la première plaque étant au droit d'une cavité de la seconde plaque, la liaison entre ces deux plaques étant assurée par la partie métallique (17) électroformée.

4. Méthode de fabrication de pièces mixtes micromécaniques silicium/métal, cette méthode comprenant les étapes suivantes :
a) dépôt sur un substrat (4) de base d'au moins une couche conductrice (3),
b) liaison d'une plaque de silicium (1) sur le substrat (4),
c) application d'une première couche de photorésist sur le silicium (1)
d) définition d'un premier motif dans ledit photorésist par procédé photolithographique,
e) gravure profonde de la plaque de silicium (1) selon le tracé ouvert dans le masque de photorésist (5) selon le premier motif,
f) élimination de la première couche de photorésist,
g) dépôt d'une seconde couche de photorésist (6, 14),
h) définition d'un second motif dans ladite seconde couche de photorésist (6, 14) par procédé photolithographique,
i) dépôt d'un métal (8, 16, 17) par électroformage sur la couche conductrice (3) du substrat (4) de base de sorte que la croissance de la couche métallique (8) remplit d'une part le volume défini par la gravure dans la plaque de silicium (1) et d'autre part le volume défini par le second motif dans ladite seconde couche de photorésist (6, 14),
j) obtention de la pièce mixte par élimination de la seconde couche de photorésist (6, 14) et séparation du substrat (4) de base.

5. Méthode de fabrication selon la revendication 4, **caractérisée en ce que** la plaque de silicium (1) est déposée sur le substrat (4) puis liée sur ledit substrat (4) par adhésion ou par des moyens électrostatiques.

6. Méthode de fabrication selon la revendication 4 **caractérisée par le fait que** le substrat (4) de base est réalisé par électroformage

7. Méthode de fabrication selon la revendication 4, **caractérisée en ce que** la plaque de silicium (1) est gravée en réalisant les étapes c) à f) avant d'être liée sur ledit substrat (4) à l'étape b) par adhésion ou par des moyens électrostatiques.

8. Méthode de fabrication selon la revendication 4, **caractérisée en ce que** les étapes c) à f) sont réalisées par l'une des techniques de gravure sélectionnée dans le groupe "Wet Etching", "Dry Etching", "Reactive Ion Etching", "Deep Reactive Ion Etching" and "Focus Ion Beam milling, FIB"

9. Méthode de fabrication selon la revendication 4, **caractérisée en ce que** la partie en silicium (9) comprend une pluralité de plaque de silicium (1) et **en ce que** les étapes c) à f) sont répétées pour structurer chaque plaque de silicium (1).

10. Méthode de fabrication selon les revendications 4 à 9, **caractérisée en ce que** la liaison entre la plaque de silicium (1) et le substrat (4) est assurée par adhésion au moyen d'une couche de photorésist intermédiaire (2), ladite couche de photorésist intermédiaire (2) étant dissoute aux endroits prévus pour le dépôt de métal (8).

11. Méthode de fabrication selon les revendications 4 à 9, **caractérisée en ce qu'**elle comprend les étapes suivantes :
- dépôt d'une troisième couche de photorésist (13) sur la seconde couche de photorésist (6, 14) polymérisée,
- polymérisation au travers d'un troisième masque de la troisième couche de photorésist et élimination de ladite troisième couche de photorésist non polymérisée,
et **en ce que** la couche métallique (8) déposée par électroformage sur la couche conductrice (3) du substrat (4) de base soit définie d'une part par le volume défini par la gravure dans la plaque de silicium (1) et d'autre part par les volumes définis par les seconde et troisième couches de photorésist polymérisées.

12. Méthode de fabrication selon la revendication 11, **caractérisée en ce qu'**elle comprend une étape intermédiaire de dépôt d'une couche conductrice sur la seconde couche de photorésist (6, 14) au moins aux endroits prévus pour recevoir la couche métallique (8) laissée accessible par la troisième couche de photorésist (13).

13. Méthode de fabrication selon l'une des revendications 4 à 9, **caractérisée en ce qu'**elle comprend une étape intermédiaire de dépôt d'une couche conductrice sur la plaque de silicium (1) gravé au moins aux endroits prévus pour recevoir la couche métallique (8) laissée accessible par la seconde couche de photorésist (6, 14).

## Patentansprüche

1. Mikromechanisches Mischstück zur Bewegung einer Uhr, das dazu bestimmt ist, mit anderen Stücken zur Bewegung einer Uhr zusammenzuwirken, mit einem Metallteil (8) und einem Teil aus Silizium (9), **dadurch gekennzeichnet, dass** das Teil aus Silizium (9) mindestens einen durchgehenden Hohlraum (7) umfasst, in dem das Metallteil (8) innig mit dem Teil aus Silizium (9) verbunden ist, als Ergebnis des Wachstums des Metallteils (8) in dem Hohlraum (7).

2. Mikromechanisches Mischstück nach Anspruch 1, **dadurch gekennzeichnet, dass** das Teil aus Silizium (9) mindestens einen leeren Hohlraum (7) umfasst und mindestens einen Hohlraum (7) mit Metallteil (8).

3. Mikromechanisches Mischstück nach Anspruch 1 oder 2, **dadurch gekennzeichnet, dass** es den Zusammenbau von mindestens zwei aufeinanderliegenden Siliziumplatten umfasst, wobei mindestens ein Hohlraum der ersten Platte gegenüber einem Hohlraum der zweiten Platte liegt, wobei die Verbindung zwischen diesen beiden Platten durch das elektroformierte Metallteil (17) gesichert ist.

4. Verfahren zur Herstellung von mikromechanischen Silizium/Metall-Mischstücken, wobei dieses Verfahren die folgenden Schritte umfasst:
a) Aufbringen mindestens einer leitenden Schicht (3) auf ein Basissubstrat (4),
b) Verbindung einer Siliziumplatte (1) auf dem Substrat (4),
c) Anbringung einer ersten Fotoresistschicht auf dem Silizium (1)
d) Definition eines ersten Motivs in der Fotoresistschicht durch ein fotolitografisches Verfahren,
e) Tiefenätzung der Siliziumplatte (1) gemäß der offenen Trasse in der Fotolackmaske (5) gemäß dem ersten Motiv,
f) Entfernung der ersten Fotoresistschicht,
g) Aufbringen einer zweiten Fotoresistschicht (6, 14),
h) Definition eines zweiten Motivs in besagter zweiter Fotoresistschicht (6, 14) durch ein fotolitografisches Verfahren,
i) Aufbringen eines Metalls (8, 16, 17) durch Elektroformverfahren auf der leitenden Schicht (3) des Basissubstrats (4), so dass das Wachstum der Metallschicht (8) einerseits das Volumen füllt, das durch das Ätzen in der Siliziumplatte (1) definiert ist, und andererseits das Volumen, das durch das zweite Motiv in besagter zweiter Fotoresistschicht (6, 14) definiert ist,
j) Erhalt des Mischstückes durch Entfernung der zweiten Fotoresistschicht (6, 14) und Abtrennung des Basissubstrats (4).

5. Herstellungsverfahren nach Anspruch 4, **dadurch gekennzeichnet, dass** die Siliziumplatte (1) auf das Substrat (4) aufgebracht wird und dann mit dem Substrat (4) durch Adhäsion oder durch elektrostatische Mittel verbunden wird.

6. Herstellungsverfahren nach Anspruch 4, **gekennzeichnet dadurch, dass** das Basissubstrat (4) durch Elektroformverfahren verwirklicht wird.

7. Herstellungsverfahren nach Anspruch 4, **dadurch gekennzeichnet, dass** die Siliziumplatte (1) geätzt wird, indem man die Phasen c) bis f) verwirklicht, bevor sie in der Phase b) durch Adhäsion oder durch elektrostatische Mittel auf dem Substrat (4) verbunden wird.

8. Herstellungsverfahren nach Anspruch 4, **dadurch gekennzeichnet, dass** die Phasen c) bis f) durch eine der Ätztechniken aus der folgenden Gruppe verwirklicht werden: "Wet Etching", "Dry Etching", "Reactive Ion Etching", "Deep Reactive Ion Etching" und "Focus Ion Beam milling, FIB".

9. Herstellungsverfahren nach Anspruch 4, **dadurch gekennzeichnet, dass** das Teil aus Silizium (9) eine Vielzahl von Siliziumplatten (1) umfasst sowie dadurch, dass die Phasen c) bis f) wiederholt werden, um jede Siliziumplatte (1) zu strukturieren.

10. Herstellungsverfahren nach den Ansprüchen 4 bis 9, **dadurch gekennzeichnet, dass** die Verbindung zwischen der Siliziumplatte (1) und dem Substrat (4) durch Adhäsion mittels einer Zwischen- Fotoresistschicht (2) gesichert wird, wobei die Zwischen- Fotoresistschicht (2) an den für das Aufbringen des Metalls (8) vorgesehenen Orten aufgelöst wird.

11. Herstellungsverfahren nach den Ansprüchen 4 bis 9, **dadurch gekennzeichnet, dass** sie die folgenden Schritte umfasst:
- Aufbringen einer dritten Fotoresistschicht (13) auf die zweite polymerisierte Fotoresistschicht (6, 14),
- Polymerisation, durch eine dritte Maske, der dritten Fotoresistschicht und Entfernung der nicht polymerisierten dritten Fotoresistschicht,
sowie dadurch, dass die durch Elektroformverfahren auf die leitende Schicht (3) des Basissubstrats (4) aufgebrachte Metallschicht (8) einerseits durch das Volumen, das durch das Ätzen in der Siliziumplatte (1) definiert ist, und andererseits durch die Volumina, die durch die zweite und dritte polymerisierte Fotoresistschicht definiert sind.

12. Herstellungsverfahren nach Anspruch 11, **dadurch gekennzeichnet, dass** es eine Zwischenphase zum Aufbringen einer leitenden Schicht auf die zweite Fotoresistschicht (6, 14) mindestens an den Orten umfasst, die vorgesehen sind, um die Metallschicht (8) aufzunehmen, die durch die dritte Fotoresistschicht (13) zugänglich ist.

13. Herstellungsverfahren nach einem der Ansprüche 4 bis 9, **dadurch gekennzeichnet, dass** es eine Zwischenphase zum Aufbringen einer leitenden Schicht auf die Siliziumplatte (1) umfasst, die mindestens an den Orten eingeätzt wird, die vorgesehen sind, um die Metallschicht (8) aufzunehmen, die durch die zweite Fotoresistschicht (6, 14) zugänglich ist.

## Claims

1. Mixed micromechanical part of watch movement intended for interacting with other parts of the watch movement, comprising a metal part (8) and a silicon part (9), **characterized in that** the silicon part (9) comprises at least one through cavity (7) in which the metal part (8) is intimately tied to the silicon part (9) resulting from the growth of said metal part (8) in said cavity (7).

2. Mixed micromechanical part according to claim 1, **characterized in that** the silicon part (9) includes at least one empty cavity (7) and at least one cavity (7) with a metal part (8).

3. Mixed micromechanical part according to claim 1 or 2, **characterized in that** it comprises the assembly of at least two superposed silicon plates, at least one cavity of the first plate being in line with a cavity of the second plate, the connection between these two plates being ensured by the electroformed metal part (17).

4. Manufacturing method of mixed silicon/metal micromechanical parts, this method comprising the following steps:
a) depositing on a base substrate (4) at least one conductive layer (3),
b) tying a silicon plate (1) to the substrate (4),
c) applying a first photoresist layer to the silicon (1)
d) defining a first pattern in said photoresist by a photolithographic process,
e) deep etching the silicon plate (1) according to the outline opened in the photoresist mask (5) according to the first pattern,
f) removing the first photoresist layer,
g) depositing a second photoresist layer (6, 14),
h) defining a second pattern in said second photoresist layer (6, 14) by photolithographic process,
i) depositing a metal (8, 16, 17) by electroforming on the conductive layer (3) of the base substrate (4) so that the growth of the metal layer (8) fills on the one hand the volume defined by the etching in the silicon plate (1) and on the other hand the volume defined by the second pattern in said second photoresist layer (6, 14),
j) obtaining the mixed part by eliminating the second photoresist layer (6, 14) and separating the base substrate (4).

5. Manufacturing method according to claim 4, **characterized in that** the silicon plate (1) is deposited on the substrate (4) and then tied to said substrate (4) by adhesion or by electrostatic means.

6. Manufacturing method according to claim 4 **characterized in that** the base substrate (4) is produced by electroforming.

7. Manufacturing method according to claim 4, **characterized in that** the silicon plate (1) is etched by performing steps c) to f) before being tied to said substrate (4) in step b) by adhesion or by electrostatic means.

8. Manufacturing method according to claim 4, **characterized in that** steps c) to f) are performed by one of the etching techniques selected from the group "Wet Etching", "Dry Etching", "Reactive Ion Etching", "Deep Reactive Ion Etching" and "Focus Ion Beam milling, FIB"

9. Manufacturing method according to claim 4, **characterized in that** the silicon part (9) includes a plurality of silicon plates (1) and **in that** steps c) to f) are repeated to structure each silicon plate (1).

10. Manufacturing method according to claims 4 to 9, **characterized in that** the connection between the silicon plate (1) and the substrate (4) is ensured by adhesion by means of an intermediate photoresist layer (2), said intermediate photoresist layer (2) being dissolved at places foreseen for depositing metal (8).

11. Manufacturing method according to claims 4 to 9, **characterized in that** it comprises the following steps:
- depositing a third photoresist layer (13) on the second polymerized photoresist layer (6, 14),
- polymerizing the third photoresist layer through a third mask and removing said third non-polymerized photoresist layer,
and **in that** the metal layer (8) deposited by electroforming on the conductive layer (3) of the base substrate (4) is defined on the one hand by the volume defined by the etching in the silicon plate (1) and on the other hand by the volumes defined by the second and third polymerized photoresist layers.

12. Manufacturing method according to claim 11, **characterized in that** it comprises an intermediate step of depositing a conductive layer on the second photoresist layer (6, 14) at least at the places foreseen for receiving the metal layer (8) left accessible by the third photoresist layer (13).

13. Manufacturing method according to one of claims 4 to 9, **characterized in that** it comprises an intermediate step of depositing a conductive layer on the silicon plate (1) etched at least at the places foreseen for receiving the metal layer (8) left accessible by the second photoresist layer (6, 14).
